## Europäisches Patentamt
## European Patent Office
## Office européen des brevets

(19)

(11) Veröffentlichungsnummer: **0 106 189**
**B1**

(12) **EUROPÄISCHE PATENTSCHRIFT**

(45) Veröffentlichungstag der Patentschrift: **17.05.89**

(51) Int. Cl.⁴: **H 03 H 9/64,** H 03 H 3/08

(21) Anmeldenummer: **83109265.5**

(22) Anmeldetag: **19.09.83**

(54) Oberflächenwellenfilter sowie Verfahren zur Herstellung des Oberflächenwellenfilters.

(30) Priorität: **21.09.82 DE 3234955**

(43) Veröffentlichungstag der Anmeldung:
**25.04.84 Patentblatt 84/17**

(45) Bekanntmachung des Hinweises auf die
Patenterteilung:
**17.05.89 Patentblatt 89/20**

(84) Benannte Vertragsstaaten:
**BE DE FR GB**

(56) Entgegenhaltungen:
**PATENTS ABSTRACTS OF JAPAN, Band 6, Nr. 67, 28. April 1982, Seite (E-104) 945r & JP - A - 57 - 7611**
**PATENTS ABSTRACTS OF JAPAN, Band 4, Nr. 157, 4. November 1980, Seite (E-32) 639r & JP - A - 55 109 018**
**ELECTRONIC DESIGN, Band 30, Nr. 11, 27. Mai 1982, Seiten 63E-64E, Denville US; "Smaller monolithic SAW filter is being readied"**

(73) Patentinhaber: **Siemens Aktiengesellschaft**
**Berlin und München**
**Wittelsbacherplatz 2**
**D-8000 München 2 (DE)**

(72) Erfinder: **Angerer, Heinrich, Ing. grad.**
**Hechtstrasse 9**
**D-8000 München 82 (DE)**
Erfinder: **Sinha, Badri**
**Unnützstrasse 23**
**D-8000 München 82 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 106 189 B1

**Beschreibung**

Die Erfindung betrifft ein Oberflächenwellenfilter mit einem plättchenförmigen Substrat aus einkristallinem, piezoelektrischem Werkstoff, insbesondere Lithiumniobat, dessen mit Ein= und Ausgangswandler, die ggf. über einen Koppler miteinander gekoppelt sind, und mit Anschlußbahnen beschichtete Substratseite zu wesentlichen Teilen mit einer Dämpfungsschicht bedeckt ist.

Zu ihrer Herstellung wird üblicherweise auf das Substrat eine Metallschicht aufgedampft, aus der mit Hilfe der Fotoätztechnik die Wandler, Koppler und Anschlußbahnen samt ihren Enden herausgearbeitet werden. Das so bemusterte Substrat wird auf ein Trägerblech aufgeklebt und die Enden der Anschlußbahnen durch Drahtbonden mit den Anschlußbeinen des Filters elektrisch verbunden. Das System wird danach in ein Kunststoffgehäuse eingesetzt und vergossen.

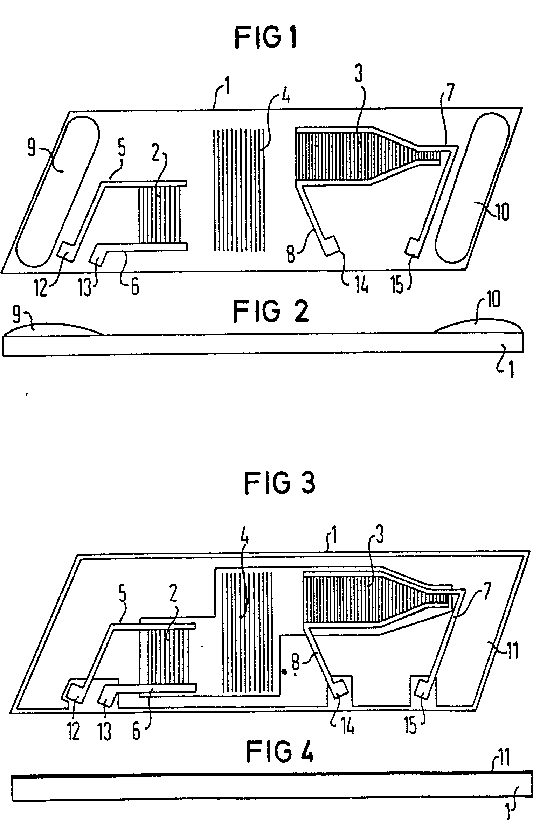

Werden dem Eingangswandler elektrische Signale zugeführt, so sendet er im gleichen Rhythmus Oberflächenwellen in verschiedenen Richtungen aus. Der Koppler greift dabei einen Teil und zwar den zum Koppler gerichteten Teil auf und sendet ihn auch in Richtung zum Ausgangswandler weiter, der die Oberflächenwellen wieder in elektrische Signale zurückwandelt. Durch technologische Maßnahmen werden reflektierte, insbesondere an Schnittkanten der Substrate entstehende und auch durch Kristallaufbaufehler im Substrat verursachte und somit zeitverzögerte Wellen teilweise unterdrückt. Beispielsweise wird zu diesem Zweck - wie dies schematisch in FIG 1 und 2 in Draufsicht bzw. Seitenansicht dargestellt ist - auf die Flächen zwischen den Substratstirnkanten und den Wandlern 2, 3 eine Bedämpfungsmasse 9, 10, bestehend aus einem Heißkleber, aufgeschmolzen. Verfahrensbedingt kann jedoch nur eine verhältnismäßig kleine Fläche parallel zu den Schnittkanten der Chip-Fläche bedämpft werden. Unerwünschte Reflektionen von Wellen, die störend auf die Wandler 2, 3 und den Koppler 4 einwirken, die sämtlich auf ein Substrat 1 aufgebracht sind, sind daher trotz dieser Bedämpfungsmassen unvermeidbar.

Gemäß "Patents Abstracts of Japan, Bd. 4, Nr. 157, 4. November 1980, Seite (E-32)(639)" wird anstelle des Heißleiters auch fotosensitives Material verwendet; jedoch beschränkt sich dessen Anwendung wiederum lediglich auf den Bereich zwischen Substratstirnkante und Wandler, womit gleichfalls keine ausreichende Dämpfung erzielbar ist.

In "Patents Abstrats of Japan, Bd. 6, Nr. 67, 28. April 1982, Seite (E-104)(945)", wird schließlich ein Oberflächenwillenfilter behandelt, das zwar eine ausreichend große Bedämpfungsfläche besitzt, jedoch läßt die aufgebrachte Bedämpfungsmasse, deren Beschaffenheit nicht genannt ist, lediglich geringfügige Teile der Filteroberfläche frei, nämlich den Bereich einer einzelnen Anschlußstelle und einen Bereich des Weges der Wellenausbreitung.

Der vorliegenden Erfindung liegt die Aufgabe zugrunde, ein Oberflächenwellenfilter der eingangs genannten Art zu schaffen, das bei gleichzeitiger Vermeidung der Nachteile der erstgenannten bekannten Filter sich die Vorteile der weitgehend mit Dämpfungsmasse bedeckten Filter zu eigen macht, jedoch unter Ausnutzung der Vorteile der fotosensitiven Werkstoffe und unter Vermeidung der beim letztgenannten bekannten Filter nahezu vollständigen Bedeckung der Substratoberfläche mit der Bedämpfungsmasse.

Zur Lösung dieser Aufgabe sieht die Erfindung bei einem Oberflächenwellenfilter gemäß Oberbegriff des Anspruchs 1 vor, daß die gesamte Substratseite, ausgenommen die Fläche, die durch den Wandler - falls vorhanden - , den Koppler, sämtliche Enden der elektrischen Anschlußbahnen und die Bereiche zwischen den Wandlern und dem Koppler begrenzt ist, durch eine Bedämpfungsschicht aus Fotolack auf Kunstharzbasis bedeckt ist.

Durch diese Bedeckung der freien Flächen mittels Bedämpfungsschicht können nicht nur die an den Schnittkanten des Substrats auftretenden Reflexionen unterdrückt werden, sondern auch die Reflexionen, die durch verschiedenste Kristallaufbaufehler im Substrat entstehen.

Der Auftrag der Bedämpfungsschicht auf die entsprechend gewählten Flächen des Substrats erfolgt gemäß einem Vorschlag nach der Erfindung mittels fotolithographischem Verfahren. Es ermöglicht eine lagegenaue Strukturierung der Bedämpfungsschicht, so daß der bedämpfungsschichtfreie Bereich der Chip-Fläche auf ein Minimum begrenzt werden kann. Wird dieses Verfahren i.ü. bereits bei Bearbeitung der Wafer, d.h. bei Bearbeitung der in zahlreiche Chips aufgegliederten, jedoch noch nicht mechanisch zertrennten Substratscheibe angewendet, so ergibt sich eine erhebliche kostensparende Fertigung. Als Fotolacke eignen sich bevorzugt Resiste auf Kunstharzbasis, die im Negativ- oder Positivfotolithographieverfahren verarbeitet und in einer Schichtdicke von vorzugsweise größer 10 µm auf das Substrat aufgetragen werden.

Die Erfindung wird nachstehend anhand des in Figur 3 schematisch in Draufsicht und in Figur 4 in Seitenansicht gezeigten Ausführungsbeispiels näher erläutert.

Mit gleichen Bezugszeichen sind dabei die Eingangs- und Ausgangswandler 2 bzw. 3, der streifenförmige Koppler 4 und die Anschlußbahnen 5, 6, 7 und 8 samt ihren Enden (12, 13, 14, 15) bezeichnet. Die Wandler bestehen, wie an sich bekannt, aus fingerartig ineinandergreifenden Elektroden. Eine Bedämpfungsschicht 11 aus Fotolack auf Kunstharzbasis bedeckt die gesamte Substratseite, ausgenommen die Fläche, die durch die Wandler 2, 3, den Koppler 4, die Enden (12, 13, 14, 15) der elektrischen Anschlußbahnen 5, 6, 7, 8 und die Bereiche zwischen den Wandlern 2, 3 und dem Koppler 4 begrenzt ist.

**Patentansprüche**

1. Oberflächenwellenfilter mit einem plättchenförmigen Substrat aus einkristallinem, piezoelektrischem Werkstoff, insbesondere Lithiumniobat, dessen mit Ein= und Ausgangswandlern, die ggf. über einen Koppler miteinander gekoppelt sind, und mit Anschlußbahnen beschichte Substratseite zu wesentlichen Teilen mit einer Dämpfungsschicht bedeckt ist, dadurch gekennzeichnet, daß die gesamte Substratseite, ausgenommen die Fläche, die durch die Wandler (2, 3), den Koppler (4), sämtliche Enden (12, 13, 14, 15) der elektrischen Anschlußbahnen (5, 6, 7, 8) und die Bereiche zwischen den Wandlern und dem Koppler begrenzt ist, durch eine Bedämpfungsschicht (11) aus Fotolack auf Kunstharzbasis bedeckt ist.

2. Oberflächenwellenfilter nach Anspruch 1, dadurch gekennzeichnet, daß für die Bedämpfungsschicht positive oder negative Fotolacke als Bedämpfungsmasse vorgesehen sind.

3. Verfahren zur Herstellung eines Oberflächenwellenfilters nach Anspruch 1, dadurch gekennzeichnet, daß die Bedämpfungsmasse (11) mittels fotolithographischem Verfahren auf das Substrat aufgetragen wird.

**Revendications**

1. Filtre à ondes acoustiques de surface comportant un substrat en forme de plaquette, fait avec un matériau monocristallin, piézoélectrique, en particulier du niobate de lithium, dont les transducteurs d'entrée et de sortie, pouvant éventuellement être couplés par l'intermédiaire d'un coupleur et dont le côté du substrat, qui est pourvu de pistes de branchement, est recouvert pour l'essentiel, d'une couche d'atténuation, caractérisé par le fait que la totalité du côté du substrat, à l'exception de la surface qui est délimitée par les transducteurs (2, 3), par le coupleur (4), par la totalité des pistes électriques de branchement (5, 6, 7, 8) et les zones entre les transducteurs et le coupleur, est recouverte d'une couche d'atténuation (11) faite avec un vernis photosensible à base d'une résine synthétique.

2. Filtre à ondes acoustiques de surface selon la revendication 1, caractérisé par le fait que l'on prévoit pour la couche d'atténuation une masse d'atténuation formée par des vernis photosensibles positifs ou négatifs.

3. Procédé pour la fabrication d'un filtre à ondes acoustiques de surface selon la revendication 1, caractérisé par le fait que la masse d'atténuation (11) est déposée sur le substrat à l'aide d'un procédé photolitographique.

**Claims**

1. Surface-acoustic wave filter having a wafer-shaped substrate of monocrystalline, piezoelectric material, especially lithium niobate, whose substrate side, which is coated with input and output transducers, which are coupled with one another via a coupler, if necessary, and with connector tracks, is covered in large parts with a damping layer, characterised in that the entire substrate side, with the exception of the area which is bounded by the transducers (2, 3), the coupler (4), all the ends (12, 13, 14, 15) of the electric connector tracks (5, 6, 7, 8) and the regions between the transducers and the coupler, is covered with a damping layer (11) of photoresist on a synthetic resin basis.

2. Surface-acoustic wave filter according to Claim 1, characterised in that positive or negative photoresists are provided as damping substance for the damping layer.

3. Method of producing a surface-acoustic wave filter according to Claim 1, characterised in that the damping substance (11) is applied to the substrate by means of a photolithographic method.

# FIG 1

# FIG 2

# FIG 3

# FIG 4